# FASCICULE DE BREVET EUROPEEN

(11) **EP 2 378 294 B1**
(45) Date de publication et mention de la délivrance du brevet: **08.08.2018**
(21) Numéro de dépôt: 11354013.2
(22) Date de dépôt: 11.04.2011
(51) Int. Cl.: G01R 15/04, H03H 7/24

(54) **Dispositif de mesure à diviseur de tension électrique**
Messvorrichtung mit einem elektrischen Spannungsteiler
Measurement device with an electric voltage divider

(30) Priorité: 13.04.2010 FR 1001539
(43) Date de publication de la demande: 19.10.2011
(73) Titulaire: Schneider Electric Industries SAS, 92500 Rueil-Malmaison (FR)
(72) Inventeur: Adam, Gérard, 38050 Grenoble Cedex 09 (FR)
(74) Mandataire: Tripodi, Paul

(56) Documents cités:
- DD-A1- 126 801
- DE-A1- 1 516 244
- DE-A1- 19 508 582
- DE-A1- 19 537 155
- DE-A1- 19 841 164
- GB-A- 2 168 495
- JP-A- 58 178 262
- RACZ B ET AL: "Fast high-voltage resistive pulse divider", MEASUREMENT SCIENCE AND TECHNOLOGY, IOP, BRISTOL, GB, vol. 3, no. 9, 1 septembre 1992 (1992-09-01), pages 926-928, XP020065307, ISSN: 0957-0233, DOI: DOI:10.1088/0957-0233/3/9/021

## Description

### DOMAINE TECHNIQUE

L'invention concerne un dispositif de mesure à diviseur de tension électrique comportant :
- une première résistance de mesure connectée entre une entrée de mesure de tension et un point commun,
- une seconde résistance de mesure connectée entre ledit point commun et une masse électrique de référence,
- une sortie de mesure connectée audit point commun,
- une enveloppe extérieure de blindage entourant lesdites première et seconde résistances de mesure connectée à ladite masse électrique de référence, et
- une électrode capacitive intérieure entourant lesdites première et seconde résistances de mesure et disposée à l'intérieur de ladite enveloppe extérieure de blindage.

### ETAT DE LA TECHNIQUE

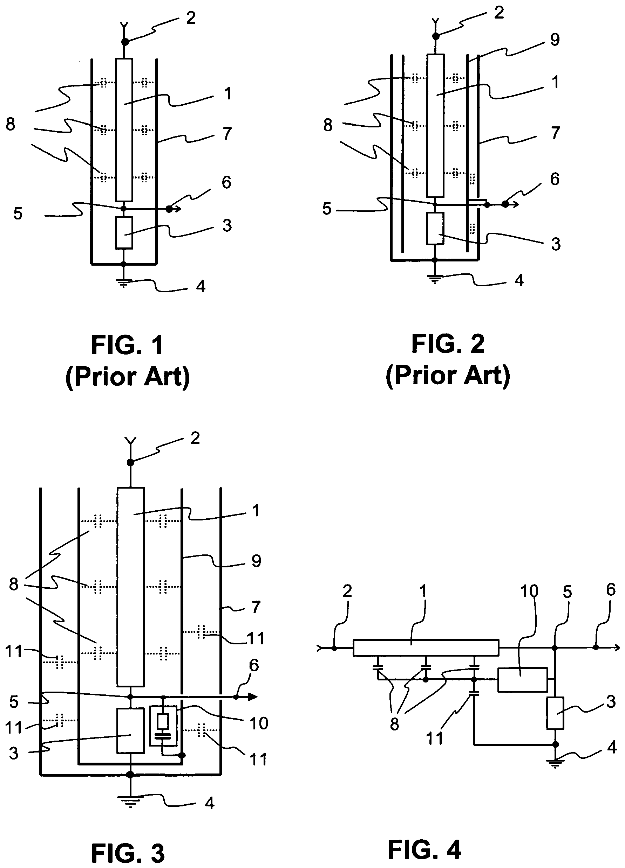

Les dispositifs de mesure de tension en moyenne ou haute tension électrique connus représentés sur la figure 1 comportent une première résistance 1 de forte valeur connectée a une entrée 2 de mesure haute tension et une seconde résistance 3 de pied de faible valeur connectée à une masse électrique 4. Les deux résistances sont reliées à un point commun 5 pour former un pont résistif. Le point commun 5 est relié à une sortie 6 de mesure du pont résistif. De manière connue, des diviseurs résistifs à haute tension sont disposés dans une enveloppe extérieure 7 de blindage entourant les résistances de mesure 1 et 3. Dans une telle disposition, des capacités parasites 8 apparaissent entre la résistance 1 et l'enveloppe extérieure reliée à la masse. Ces condensateurs sont repartis sur la longueur de la résistance 1 et de l'enveloppe extérieure 7. Ainsi, la résistance de mesure 1 et les condensateurs 8 forment un filtre passe bas réparti. Un tel filtre génère un déphasage du signal de sortie par rapport au signal de tension d'entrée et atténue les fréquences élevées du signal, en particulier les harmoniques.

D'autres dispositifs représentés sur la figure 2 comportent une électrode capacitive intérieure 9 entourant les résistances de mesure 1 et 3. Cette électrode, généralement disposée à l'intérieur de l'enveloppe extérieure de blindage 7, est raccordée à la sortie la sortie de mesure 6. Un tel dispositif est décrit dans la demande de brevet DE19841164.

Les dispositifs comportant une électrode capacitive intérieure ont un déphasage amélioré. Cependant, le déphasage est encore trop élevé pour utiliser ces dispositifs dans des systèmes de mesure de puissance électrique. De plus, avec ces dispositifs la mesure de signaux comportant des harmoniques de rangs élevés n'est pas suffisamment précise.

### EXPOSE DE L'INVENTION

L'invention a pour but un dispositif de mesure à diviseur de tension ayant un déphasage réduit, permettant la mesure de signaux harmoniques de rangs élevés et ayant une faible dérive du déphasage en température.

Dispositif de mesure à diviseur de tension électrique selon l'invention comportant :
- une première résistance de mesure connectée entre une entrée de mesure de tension et un point commun,
- une seconde résistance de mesure connectée entre ledit point commun et une masse électrique de référence,
- une sortie de mesure connectée audit point commun,
- une enveloppe extérieure de blindage entourant lesdites première et seconde résistances de mesure connectée à ladite masse électrique de référence, et
- une électrode capacitive intérieure entourant lesdites première et seconde résistances de mesure et disposée à l'intérieur de ladite enveloppe extérieure de blindage,
comporte un circuit de compensation de déphasage connecté entre ladite électrode capacitive intérieure et ledit point commun, ledit circuit de compensation comportant au moins un composant électronique ayant une grandeur électrique variable en fonction de la température.

Dans un mode de réalisation préférentiel, le circuit de compensation est un circuit dipôle à deux entrée-sortie. De préférence, le circuit de compensation est un circuit à avance de phase. De préférence, le circuit de compensation comporte au moins une résistance et un condensateur.

Selon une première variante, le circuit de compensation est disposé à l'intérieur de la dite électrode capacitive intérieure.

Selon une seconde variante, ladite électrode capacitive intérieure est connectée à une sortie de compensation et le circuit de compensation est connecté entre ladite sortie de compensation et ladite sortie de mesure.

Avantageusement, la première résistance de mesure a une valeur supérieure à 50 mégohms.

Dans un mode de réalisation particulier, le dispositif comporte :
- une première couche isolante entre ladite enveloppe extérieure de blindage et ladite électrode capacitive intérieure, et
- une seconde couche isolante entre ladite électrode capacitive intérieure et ladite première résistance de mesure,
la première et la seconde couche isolante ayant des variations des caractéristiques diélectriques en fonction de la température sensiblement identiques.

### BREVE DESCRIPTION DES DESSINS

D'autres avantages et caractéristiques ressortiront plus clairement de la description qui va suivre, de modes particuliers de réalisation de l'invention, donnés à titre d'exemples non limitatifs, et représentés aux dessins annexés sur lesquels :
- Les figures 1 et 2 représentent des dispositifs de mesure à pont résistifs de l'état de la technique ;
- la figure 3 représente un dispositif de mesure selon un premier mode de réalisation de l'invention ;
- la figure 4 représente un premier schéma de modélisation d'un dispositif selon un mode de réalisation de l'invention ;
- la figure 5 représente un dispositif de mesure selon un second mode de réalisation de l'invention ;
- la figure 6 représente un second schéma de modélisation d'un dispositif selon un mode de réalisation de l'invention ;
- Les figures 7 à 9 représentent des schémas de circuits de compensation utilisés dans des dispositifs selon l'invention.

### DESCRIPTION DETAILLEE DE MODES DE REALISATION PREFERES

La figure 3 représente un dispositif de mesure à diviseur de tension électrique comportant une première résistance de mesure 1 connectée entre une entrée 2 de mesure de tension et un point commun 5, une seconde résistance de mesure 3 connectée entre ledit point commun 5 et une masse électrique de référence 4, et une sortie 6 de mesure connectée audit point commun. Le dispositif comporte aussi une enveloppe extérieure 7 de blindage entourant les première et seconde résistances 1 et 3 de mesure et connectée à ladite masse électrique de référence. L'enveloppe 7 protège les résistances contre les perturbations électromagnétiques et électrostatiques extérieures au dispositif. Une électrode capacitive intérieure 9 de compensation entourant lesdites première et seconde résistances de mesure 1 et 3 est disposée à l'intérieur de ladite enveloppe extérieure de blindage. Elle permet de ramener vers le signal de sortie des signaux recueillis par la liaison capacitive avec les résistances.

Selon l'invention, le dispositif comporte un circuit 10 de compensation de déphasage connecté entre ladite électrode capacitive intérieure 9 de compensation et ledit point commun 5. Le circuit de compensation 9 comporte des composants électroniques permettant de compenser précisément le déphasage entre le signal de sortie sur la sortie 6 et le signal haute tension d'entrée sur l'entrée 2. Le circuit de compensation permet aussi de garantir une atténuation du signal quasi constante sur une bande passante du signal à mesurer afin de mesurer des harmoniques de rangs élevés. Par exemple, la bande passante à mesurer sera de préférence entre la fréquence fondamentale et la treizième harmonique (rang 13).

Dans le mode réalisation de la figure 3, le circuit de compensation 10 est disposé à l'intérieur de l'électrode capacitive intérieure 9. Le circuit 10 se présente sous la forme d'un circuit imprimé comportant les composants électroniques.

La figure 4 représente un premier schéma de modélisation d'un dispositif selon un mode de réalisation de l'invention. Les résistances 1 et 3 forment un pont diviseur résistif, les condensateurs répartis 8 entre la résistance 1 et l'électrode capacitive intérieure 9 d'une part et des condensateurs 11 répartis entre l'électrode capacitive intérieure 9 et l'enveloppe extérieure 7 forment un diviseur capacitif. Le circuit de compensation 10 est connecté entre le diviseur capacitif et le diviseur résistif de manière à optimiser ou à réduire le déphasage conjointement avec l'augmentation de la bande passante du dispositif.

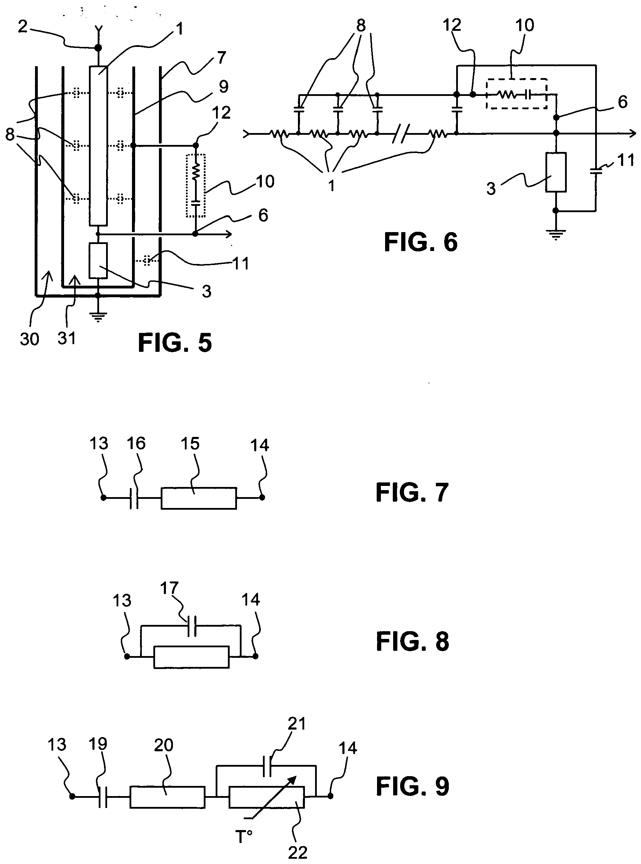

Dans le mode réalisation de la figure 5, l'électrode capacitive intérieure 9 est connectée à une sortie de compensation 12 et le circuit 10 de compensation est connecté entre la sortie de compensation 12 et la sortie de mesure 6. Le circuit 10 se présente sous la forme d'un circuit imprimé comportant les composants électroniques dans un boîtier disposé à l'extérieur de l'enveloppe extérieure 7.

La figure 6 représente un second schéma de modélisation d'un dispositif selon un mode de réalisation de l'invention. Sur ce schéma, la résistance répartie 1 et les condensateurs répartis 8 sont représentés par une succession de filtres résistance-condensateur (RC).

De préférence, le circuit de compensation est un circuit dipôle à deux entrée-sorties 13 et 14 comme représenté sur les figures 7, 8 et 9. Le circuit de compensation est dans la plupart des cas un circuit à avance de phase. Cependant, ce déphasage peut être ajusté en fonction de déphasages d'autres circuits de mesure. Par exemple, il sera ajusté en fonction d'un déphasage subit par un circuit de mesure de courant associé dans le cadre d'une mesure de puissance active ou réactive ou d'un cosinus ϕ d'une installation.

Dans des versions simplifiées, le circuit de compensation comporte une résistance 15 connecté en série avec un condensateur 16 comme sur la figure 7, ou un condensateur 17 et une résistance 18 connecté en parallèle comme sur la figure 8.

Les couches de matériaux diélectriques disposées entre la résistance 1 et l'électrode capacitive intérieure 9 et entre ladite électrode capacitive intérieure et l'enveloppe extérieure 7 peuvent avoir des caractéristiques diélectriques qui varient en fonction de la température. Ainsi, les valeurs de condensateurs 8 et 11 varient également en fonction de la température. De telles variations ont des effets sur le déphasage et la bande passante. Pour limiter ces effets, le dispositif selon un mode de réalisation de l'invention comporte une première couche isolante 30 entre ladite enveloppe extérieure de blindage et ladite électrode capacitive intérieure et une seconde couche isolante 31 entre ladite électrode capacitive intérieure et ladite première résistance de mesure réalisées avec des matériaux ayant des variations des caractéristiques diélectriques en fonction de la température sensiblement identiques. Avantageusement, le matériau est identique pour les deux couches.

Pour améliorer la compensation en fonction de la température, le circuit 10 de compensation comporte au moins un composant électronique ayant une grandeur électrique variable en fonction de la température. Sur la figure 9, le circuit de compensation est complexe. Il comporte un premier condensateur 19 en série avec une résistance 20 et en série avec une cellule RC parallèle comportant un condensateur 21 et une résistance 22 ayant une valeur variable en fonction de la température. Le coefficient de température de la résistance 22 peut être positif (CTP) ou négatif (CTN).

Le circuit de compensation décrit ci-dessus permet de réaliser un dispositif de mesure de tension ayant des résistances 1 de très forte valeur. Avantageusement, la résistance de mesure 1 a une valeur supérieure à 50 mégohms (MΩ). Les fortes valeurs de résistance permettent de limiter la puissance électrique dissipée dans les dispositifs de mesure et par conséquent de pouvoir diminuer leur volume.

Les dispositifs décrits ci-dessus sont particulièrement destinés à la mesure de moyenne tension, haute tension, ou très haute tension, par exemple de 1000 volts à 100 000 volts.

## Revendications

1. Dispositif de mesure à diviseur de tension électrique comportant :
- une première résistance de mesure (1) connectée entre une entrée (2) de mesure de tension et un point commun (5),
- une seconde résistance de mesure (3) connectée entre ledit point commun (5) et une masse électrique (4) de référence,
- une sortie de mesure (6) connectée audit point commun (5),
- une enveloppe extérieure (7) de blindage entourant lesdites première et seconde résistances de mesure connectée à ladite masse électrique (4) de référence, et
- une électrode capacitive (9) intérieure entourant lesdites première et seconde résistances de mesure et disposée à l'intérieur de ladite enveloppe extérieure (7) de blindage, dispositif **caractérisé en ce qu'**il comporte un circuit (10) de compensation de déphasage connecté entre ladite électrode capacitive (9) intérieure et ledit point commun (5), ledit circuit (10) de compensation comportant au moins un composant électronique (22) ayant une grandeur électrique variable en fonction de la température.

2. Dispositif selon la revendication 1 **caractérisé en ce que** le circuit (10) de compensation est un circuit dipôle à deux entrée-sortie (13, 14).

3. Dispositif selon l'une des revendications 1 ou 2 **caractérisé en ce que** le circuit (10) de compensation est un circuit à avance de phase.

4. Dispositif selon l'une quelconque des revendications 1 à 3 **caractérisé en ce que** le circuit (10) de compensation comporte au moins une résistance (15, 18, 20, 22) et un condensateur (16, 17, 19, 21).

5. Dispositif selon l'une quelconque des revendications 1 à 4 **caractérisé en ce que** le circuit (10) de compensation est disposé à l'intérieur de la dite électrode capacitive intérieure (9).

6. Dispositif selon l'une quelconque des revendications 1 à 5 **caractérisé en ce que** ladite électrode capacitive intérieure (9) est connectée à une sortie (12) de compensation et le circuit (10) de compensation est connecté entre ladite sortie (12) de compensation et ladite sortie (6) de mesure.

7. Dispositif selon l'une quelconque des revendications 1 à 6 **caractérisé en ce que** la première résistance (1) de mesure a une valeur supérieure à 50 mégohms.

8. Dispositif selon l'une quelconque des revendications 1 à 7 **caractérisé en ce qu'**il comporte :
- une première couche isolante (30) entre ladite enveloppe extérieure (7) de blindage et ladite électrode capacitive (9) intérieure, et
- une seconde couche isolante (31) entre ladite électrode capacitive (9) intérieure et ladite première résistance (1) de mesure,
la première et la seconde couche isolante ayant des variations des caractéristiques diélectriques en fonction de la température sensiblement identiques.

## Patentansprüche

1. Messvorrichtung mit einem Teiler für elektrische Spannung, die Folgendes umfasst:
- einen ersten Messwiderstand (1), der zwischen einen Spannungsmesseingang (2) und einen gemeinsamen Punkt (5) geschaltet ist,
- einen zweiten Messwiderstand (3), der zwischen den gemeinsamen Punkt (5) und eine elektrische Referenzmasse (4) geschaltet ist,
- einen Messausgang (6), der mit dem gemeinsamen Punkt (5) verbunden ist,
- eine äußere Abschirmungshülle (7), die den ersten und den zweiten Messwiderstand umgibt und mit der elektrischen Referenzmasse (4) verbunden ist, und
- eine innere kapazitive Elektrode (9), die den ersten und den zweiten Messwiderstand umgibt und in der äußeren Abschirmungshülle (7) angeordnet ist,
wobei die Vorrichtung **dadurch gekennzeichnet ist, dass** sie eine Phasenverschiebungs-Kompensationsschaltung (10) umfasst, die zwischen die innere kapazitive Elektrode (9) und den gemeinsamen Punkt (5) geschaltet ist, wobei die Kompensationsschaltung (10) wenigstens eine elektronische Komponente (22) enthält, die eine elektrische Größe besitzt, die sich als Funktion der Temperatur ändert.

2. Vorrichtung nach Anspruch 1, **dadurch gekennzeichnet, dass** die Kompensationsschaltung (10) eine Dipolschaltung mit Doppel-Eingang/Ausgang (13, 14) ist.

3. Vorrichtung nach Anspruch 1 oder 2, **dadurch gekennzeichnet, dass** die Kompensationsschaltung (10) eine Phasenvoreilungsschaltung ist.

4. Vorrichtung nach einem der Ansprüche 1 bis 3, **dadurch gekennzeichnet, dass** die Kompensationsschaltung (10) wenigstens einen Widerstand (15, 18, 20, 22) und einen Kondensator (16, 17, 19, 21) umfasst.

5. Vorrichtung nach einem der Ansprüche 1 bis 4, **dadurch gekennzeichnet, dass** die Kompensationsschaltung (10) innerhalb der inneren kapazitiven Elektrode (9) angeordnet ist.

6. Vorrichtung nach einem der Ansprüche 1 bis 5, **dadurch gekennzeichnet, dass** die innere kapazitive Elektrode (9) mit einem Kompensationsausgang (12) verbunden ist und die Kompensationsschaltung (10) zwischen den Kompensationsausgang (12) und den Messausgang (6) geschaltet ist.

7. Vorrichtung nach einem der Ansprüche 1 bis 6, **dadurch gekennzeichnet, dass** der erste Messwiderstand (1) einen Wert von mehr als 50 MΩ besitzt.

8. Vorrichtung nach einem der Ansprüche 1 bis 7, **dadurch gekennzeichnet, dass** sie Folgendes umfasst:
- eine erste Isolierschicht (30) zwischen der äußeren Abschirmungshülle (7) und der inneren kapazitiven Elektrode (9) und
- eine zweite Isolierschicht (31) zwischen der inneren kapazitiven Elektrode und dem ersten Messwiderstand (1),
wobei die erste und die zweite Isolierschicht elektrische Eigenschaften besitzen, die sich als Funktion der Temperatur im Wesentlichen gleich ändern.

## Claims

1. Voltage divider measurement device including:
- a first measurement resistor (1) connected between a voltage measurement input (2) and a common point (5);
- a second measurement resistor (3) connected between said common point (5) and a reference ground (4);
- a measurement output (6) connected to said common point (5);
- an outer shielding casing (7) surrounding said first and second measurement resistors that is connected to said reference ground (4); and
- an inner capacitive electrode (9) surrounding said first and second measurement resistors and positioned inside said outer shielding casing (7),
which device is **characterized in that** it includes a phase-shift compensation circuit (10) connected between said inner capacitive electrode (9) and said common point (5), said compensation circuit (10) including at least one electronic component (22) having an electrical quantity that varies with temperature.

2. Device according to Claim 1, **characterized in that** the compensation circuit (10) is a dipole circuit having two input-outputs (13, 14).

3. Device according to either of Claims 1 and 2, **characterized in that** the compensation circuit (10) is a phase lead circuit.

4. Device according to any one of Claims 1 to 3, **characterized in that** the compensation circuit (10) includes at least one resistor (15, 18, 20, 22) and one capacitor (16, 17, 19, 21).

5. Device according to any one of Claims 1 to 4, **characterized in that** the compensation circuit (10) is positioned inside said inner capacitive electrode (9).

6. Device according to any one of Claims 1 to 5, **characterized in that** said inner capacitive electrode (9) is connected to a compensation output (12) and the compensation circuit (10) is connected between said compensation output (12) and said measurement output (6).

7. Device according to any one of Claims 1 to 6, **characterized in that** the value of the first measurement resistor (1) is higher than 50 megaohms.

8. Device according to any one of Claims 1 to 7, **characterized in that** it includes:
- a first insulating layer (30) between said outer shielding casing (7) and said inner capacitive electrode (9); and
- a second insulating layer (31) between said inner capacitive electrode (9) and said first measurement resistor (1),
the first and the second insulating layer having dielectric properties that vary with temperature in a substantially identical manner.
